# EUROPEAN PATENT SPECIFICATION

(11) **EP 4 586 313 B1**
(45) Date of publication and mention of the grant of the patent: **29.04.2026**
(21) Application number: 24305070.5
(22) Date of filing: 10.01.2024
(51) Int. Cl.: H10W 40/47, H10W 40/00, F28F 3/02, F28F 9/02

(54) **COOLING BLOCK FOR COOLING A HEAT-GENERATING ELECTRONIC COMPONENT**
KÜHLBLOCK ZUR KÜHLUNG EINES WÄRMEERZEUGENDEN ELEKTRONISCHEN BAUTEILS
BLOC DE REFROIDISSEMENT POUR REFROIDIR UN COMPOSANT ÉLECTRONIQUE GÉNÉRANT DE LA CHALEUR

(43) Date of publication of application: 16.07.2025
(60) Divisional application: 26167175.4
(73) Proprietor: OVH, 59100 Roubaix (FR)
(72) Inventor: BAUDUIN, Hadrien, 59650 Villeneuve d'Ascq (FR); BAUCHART, Grégory Francis Louis, 59150 Wattrelos (FR); CHEHADE, Ali, 59283 Moncheaux (FR)
(74) Representative: BCF Global

(56) References cited:
- EP-B1- 2 372 759
- US-A1- 2009 205 543
- US-A1- 2011 232 887
- US-A1- 2019 393 132
- US-A1- 2022 153 085
- US-A1- 2022 210 947
- US-A1- 2022 381 522
- US-B1- 6 796 370

## Description

### FIELD OF TECHNOLOGY

The present technology relates to cooling blocks for cooling heat-generating electronic components.

### BACKGROUND

Heat dissipation is an important consideration for computer systems. Notably, many components of a computer system, such as a processor (also referred to as central processing unit (CPU)), generate heat and thus require cooling to avoid performance degradation and, in some cases, failure. Similar considerations arise for systems other than computer systems (e.g., power management systems). Thus, in many cases, different types of cooling solutions are implemented to promote heat dissipation from heat-generating electronic components, with the objective being to collect and conduct thermal energy away from these heat-generating electronic components. For instance, in a data center, in which multiple electronic systems (e.g., servers, networking equipment, power equipment) are continuously operating and generating heat, such cooling solutions may be particularly important. Examples of such cooling solutions may be found in US 2011/232887 A1, EP 2 372 759 B1, US 2019/393132 A1, US 2009/205543 A1, US 2022/381522 A1, US 2022/153085 A1, US 2022/210947 A1, and US 6,796,370 B1.

One example of a cooling solution is a heat sink which relies on a heat transfer medium (e.g., a gas or liquid) to carry away the heat generated by a heat-generating electronic component. For instance, a cooling block (sometimes referred to as a "water block" or "cold plate") can be thermally coupled at a thermal transfer surface to a heat-generating electronic component and water (or other fluid) is made to flow through a conduit in the cooling block to absorb heat from the heat-generating electronic component through the thermal transfer surface. As water flows out of the cooling block, so does the thermal energy collected thereby.

A consideration in cooling heat-generating electronic components is a space efficiency of the cooling solution to enable, for example, stacking of multiple cooling blocks and multiple heat-generating electronic components. The cooling block can be paired with one or more heat-generating electronic components in contact with one or both thermal transfer surfaces of the cooling block, respectively. For space efficiency, it is desirable for many cooling block - heat-generating electronic component units to be stacked together yet the size, shape and configuration of existing cooling blocks does not readily permit this.

Another consideration is minimization of a material used to make the cooling block, whilst maximising a surface area of the thermal transfer surfaces.

There is therefore a desire for a cooling block which can alleviate at least some of these drawbacks.

### SUMMARY

It is an object of the present technology to ameliorate at least some of the inconveniences present in the prior art.

According to one aspect of the present technology, there is provided a cooling block for cooling a heat-generating electronic component. Broadly, the cooling block includes a connector which is connected to a base of the cooling block. The connector is configured to fluidly connect piping of a fluid source with an inlet and/or an outlet of the cooling block. The connector is configured such that the piping does not interfere with one or more thermal transfer surfaces of the cooling block.

In certain embodiments, connection of the connector to the cooling block enables reducing a thickness of the cooling block compared to cooling blocks of the prior art which do not have a modular configuration like the present technology. The connector has a thickness which is greater than a thickness of the cooling block body. The piping is fluidly connectable to a portion of the connector that extends outwardly from the cooling block body. Another portion of the connector is received within the cooling block body. This can permit larger numbers of cooling blocks and heat-generating electronic components to be stacked together without increasing an overall footprint. For example, one cooling block could be thermally in contact with two GPUs. From one aspect, there is provided a cooling block for cooling a heat-generating electronic component, the cooling block comprising: a cooling block body defining a fluid conduit therein for circulating a cooling fluid therethrough, the fluid conduit having a conduit inlet and a conduit outlet for receiving and discharging the cooling fluid respectively, and at least one connector connected to the cooling block body at a top side of the cooling block body, the at least one connector having a connector body defining two connector passages, the two connector passages being disposed side-by-side, in fluid communication with the conduit inlet and the conduit outlet, respectively, and fluidly connectable to piping of a fluid source.

The two connector passages extend between a side face of the connector body and a lower face of the connector body.

In certain embodiments, a height of the cooling block body is less than a height of the at least one connector body.

In certain embodiments, a portion of the at least one connector protrudes outwardly from the cooling block body when the at least one connector is connected to the cooling block body. The piping can be connected to the protruding portion of the at least one connector.

In certain embodiments, the at least one connector is positioned such that the side face faces away from the cooling block. In other embodiments, the side face of the at least one connector may be parallel to the top side of the cooling block body. In yet other embodiments, the side face of the at least one connector when it is connected to the cooling block body may have any other orientation.

In certain embodiments, the two connector passages are L-shaped or T-shaped.

In certain embodiments, a cross-sectional shape of the two connector passages is circular.

In certain embodiments, a cross-sectional shape of the two connector passages is a flattened elliptical in which a width of each connector passage of the two connector passages is larger than a height of each connector passage of the two connector passages. Other cross-sectional shapes are within the scope of the present technology.

In certain embodiments, the cooling block further comprises an adaptor member connectable to an end of the two connector passages and having a cross-sectional shape which transitions, towards a distal end, from a flattened elliptical cross-sectional profile to a circular cross-sectional profile.

The at least one connector comprises two connector passages defined in the connector body, the two connector passages being disposed side-by-side.

In certain embodiments, at least a portion of the connector body has an external configuration which is cuboid. The external configuration may have rounded corners.

In certain embodiments, the cooling block body comprises a base connected to a cover, wherein the cover has at least one recessed portion, the at least one connector being connected to the base and the cover at the at least one recessed portion.

In certain embodiments, a lower portion of the at least one connector is nested adjacent the cover, and an upper portion of the connector extends outwardly beyond the cover.

In certain embodiments, a thickness of the lower portion of the at least one connector is the same as a thickness of the cover.

In certain embodiments, a surface area of a top face of the upper portion of the at least one connector is smaller than a surface area of a top face of the cover.

In examples out of the scope of the invention, but useful to understand it, the at least one connector comprises two connectors, the two connectors being connected to the top side of the cooling block at diametrically opposite sides thereof. In other examples, the two connectors may be longitudinally aligned, or laterally aligned. In yet other examples, the at least one connector may comprise any number of connectors, such as three, four or five connectors. The plurality of connectors may have any suitable positioning relative to the cooling block body and orientation. From another aspect, there is provided a connector for a cooling block, the connector having a connector body defining two connector passages, the connector is connectable to a top side of the cooling block body such that the two connector passages are in fluid communication with a conduit inlet and a conduit outlet of the cooling block, respectively, and fluidly connectable to piping of a fluid source.

The two connector passages extend between a side face of the connector body and a lower face of the connector body.

In certain embodiments, the two connector passages are L-shaped or T-shaped.

In certain embodiments, a cross-sectional shape of the two connector passages is circular.

In certain embodiments, a cross-sectional shape of the two connector passages is a flattened elliptical in which a width of each connector passage of the two connector passages is larger than a height of each connector passage of the two connector passages.

In certain embodiments, the connector further comprises an adaptor member connectable to an end of the two connector passages and having a cross-sectional shape which transitions, towards a distal end, from a flattened elliptical cross-sectional profile to a circular cross-sectional profile.

The at least one connector comprises two connector passages defined in the connector body, the two connector passages being disposed side-by-side.

In certain embodiments, the connector body of the at least one connector has an external configuration which is cuboid. In certain embodiments, the external configuration may have one or more rounded corners.

From a yet further aspect, there is provided a method of assembling a cooling block, the cooling block comprising a cooling block body defining a fluid conduit therein for circulating a cooling fluid therethrough, the fluid conduit having a conduit inlet and a conduit outlet for receiving and discharging the cooling fluid respectively. The method comprises providing at least one connector having a connector body defining therein two connector passages being disposed side-by-side; and connecting the at least one connector to the cooling block body at a top side of the cooling block body such that the at least one connector is in fluid communication with one or both of the conduit inlet and the conduit outlet of the cooling block.

The at least one connector is oriented such that the two connector passages extend between a side face of the connector body to a lower face of the connector body, the lower face of the connector body being in contact with the top side of the cooling block.

In certain embodiments, the connecting the at least one connector to the cooling block comprises welding the at least one connector to the cooling block.

Embodiments of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of embodiments of the present technology will become apparent from the following description, the accompanying drawings and the appended claims.

It is to be understood that terms relating to the position and/or orientation of components such as "upper", "lower", "top", "bottom", "front", "rear", "left", "right", "longitudinal", "lateral", "vertical", etc. are used herein to simplify the description and are not intended to be limitative of the particular position/orientation of the components in use.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 is a perspective view, taken from a top, front, left side, of a cooling block which includes two connectors, according to examples useful to understand but out of the scope of the present technology;
FIG. 2 is a cross-sectional view of the cooling block of FIG. 1 taken along line 2-2 in FIG. 1, and showing heat-generating electronic components cooled thereby;
FIG. 3 is a top plan view of a base of the cooling block of FIG. 1;
FIG. 4 is a cross-sectional view of the cooling block of FIG. 1 taken along line 3-3 in FIG. 1, and showing heat-generating electronic components cooled thereby;
FIG. 5 is a a perspective view taken from a top front, left side, of a cooling block which includes one connector, according to of the present technology;
FIG. 6 is a perspective view of one of the two connectors of FIG. 1;
FIG. 7 is a perspective view of one of the two connectors of FIG. 1;
FIG. 8A is an adaptor member for fluidly connecting with the connector of FIG. 7;
FIG. 8B is the adaptor member of FIG. 8A connected to the connector of FIG. 7;
FIG. 9 is a perspective view of the connector of FIG. 5, according to embodiments of the present technology;
FIG. 10 is a perspective view of the connector of FIG. 5, according to other embodiments of the present technology;
FIG. 11 is two adaptor members of FIG. 8A connected to the connector of FIG. 10;
FIG. 12 is a perspective view of the connector of FIG. 1; and
FIG. 13 is a flow diagram illustrating a method for assembling one or more of the cooling blocks of FIGs. 1 or 5, according to embodiments of the present technology. The figures are not necessarily to scale.

### DETAILED DESCRIPTION

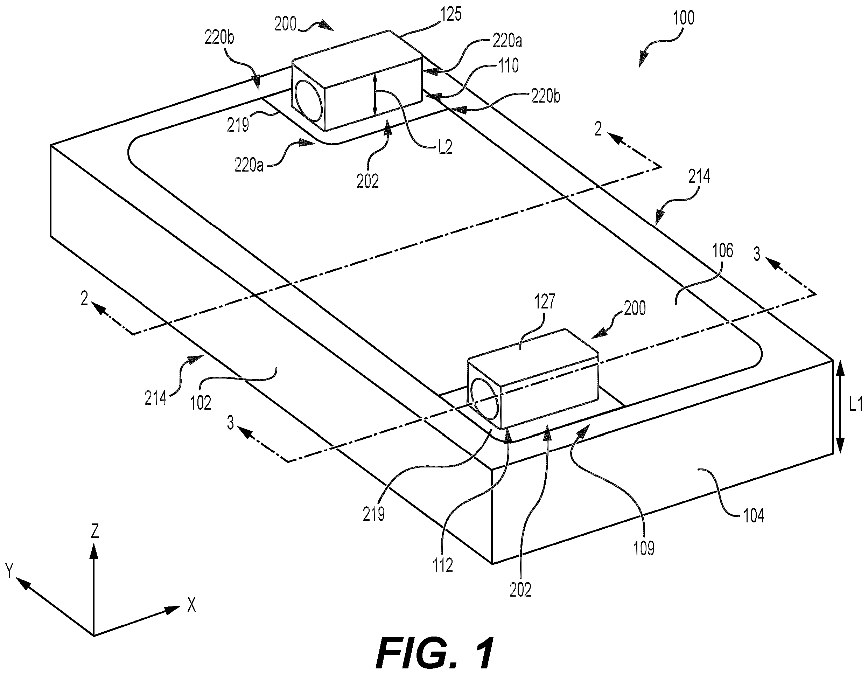

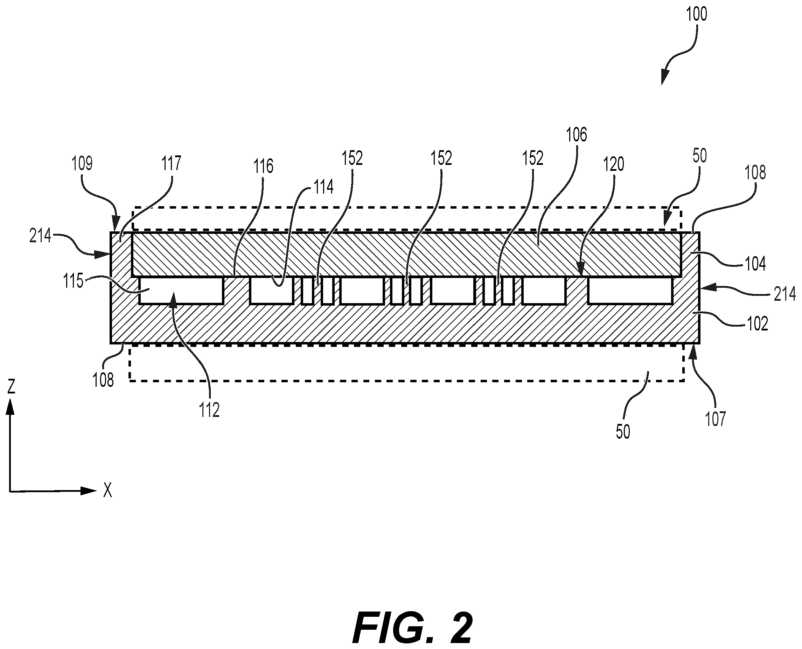

FIGs. 1 and 2 illustrate a cooling block 100 in accordance with an an example useful to understand but out of the scope of the present technology. The cooling block 100 is configured for cooling one or more heat-generating electronic components 50 (illustrated schematically in FIG. 2). In this example, the heat-generating electronic components 50 are graphics processing units (GPU) which are sandwiched the cooling block 100. In other embodiments, the heat-generating electronic component 50 is a central processing unit (CPU), such as a server operating within a data center. It is contemplated that the heat-generating electronic component 50 could be any other suitable heat-generating electronic component (e.g., a, a semiconductor, a memory unit, etc.). In use, the heat-generating electronic component 50 generates a significant amount of heat and can therefore benefit from cooling.

As will be described in detail below, the cooling block 100 is configured, via a modular configuration, to minimise a height of a cooling block body (and hence material costs) whilst not compromising on the available surface area for contacting the heat-generating electronic component 50. This can allow for larger heat-generating electronic components 50 to be cooled by the cooling block 100, and/or multiple heat-generating electronic components 50 to be simultaneously cooled by the cooling block 100.

Embodiments of the cooling block 100 will now be described with reference to FIGs. 1 to 4. The cooling block 100 has a body 102 including a base 104 and a cover 106 which are connected to each other. For instance, in this example, the cover 106 is welded to the base 104 (e.g., via laser welding). The cover 106 may be fixed to the base 104 differently in other embodiments. As shown in FIG. 2, the cooling block 100 has a thermal transfer surface 108 disposed on a lower side 107 of the cooling block 100 (which is also a lower side of the base 104), as well as on a top side 109 of the cooling block 100 (which is also a top side of the cover 106). In other embodiments, only one of the lower side 107 and the top side 109 of the cooling block 100 are configured for thermal transfer. The thermal transfer surface 108 is configured to be placed in thermal contact with the heat-generating electronic component 50. It is to be understood that the thermal transfer surface 108 can be in thermal contact with the heat-generating electronic component 50 whether the thermal transfer surface is in direct contact with the heat-generating electronic component 50 or a thermal interface material (not shown) (e.g., a thermal paste, a thermal pad, a graphite sheet, etc.) is disposed therebetween with the express intention of improving the heat transfer between the heat-generating electronic component 50 and the cooling block 100.

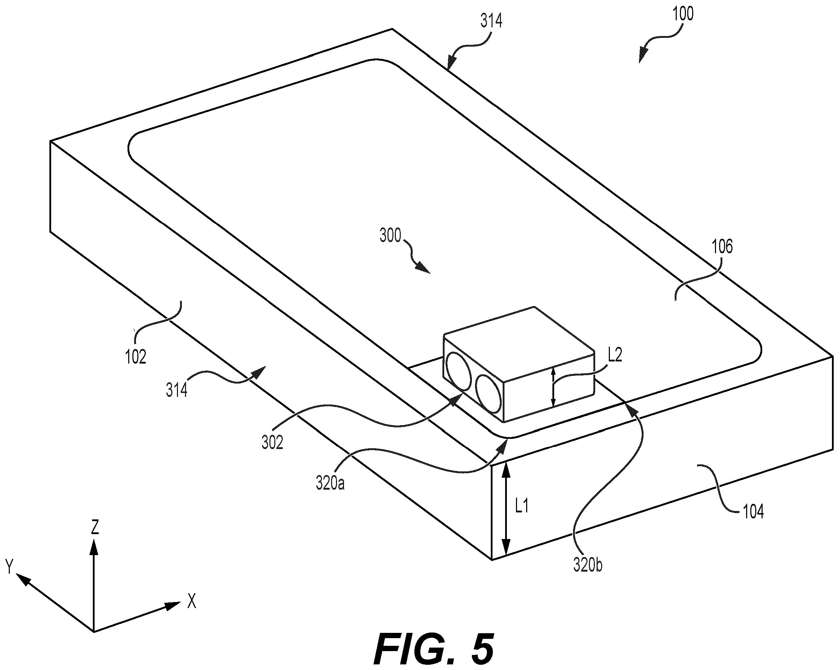

As shown in FIGs. 2 to 4, together, the base 104 and the cover 106 define the internal fluid conduit 115 within which a cooling fluid is circulated to absorb heat from the heat-generating electronic component 50. The internal fluid conduit 115 extends from an inlet 110 to an outlet 112. In this example, the inlet 110 and the outlet 112 are disposed near opposite corners of the cooling block 100. The inlet 110 and the outlet 112 could be disposed at different locations in other embodiments. For example, the inlet 110 and the outlet 112 could be disposed at the same location, which will be described with reference to FIG. 5. Or for example, the inlet 110 and the outlet 112 may be provided at different locations and longitudinally, laterally or diagonally aligned with respect to the body 102 of the cooling block 100.

In this embodiment, the cooling fluid circulated through the internal fluid conduit 115 is demineralized water. However, the cooling fluid may be any other suitable cooling fluid (e.g., a refrigerant) in other embodiments. In some embodiments, the cooling fluid may be capable of two-phase flow such that the cooling fluid can change phases from liquid to gas and vice-versa based on a temperature thereof. The cooling fluid circulating within the cooling block 100 will thus, at some point, be in the liquid phase, however the cooling fluid may not necessarily be in the liquid phase throughout (e.g., the cooling fluid may evaporate from liquid to gas when its temperature reaches a certain value).

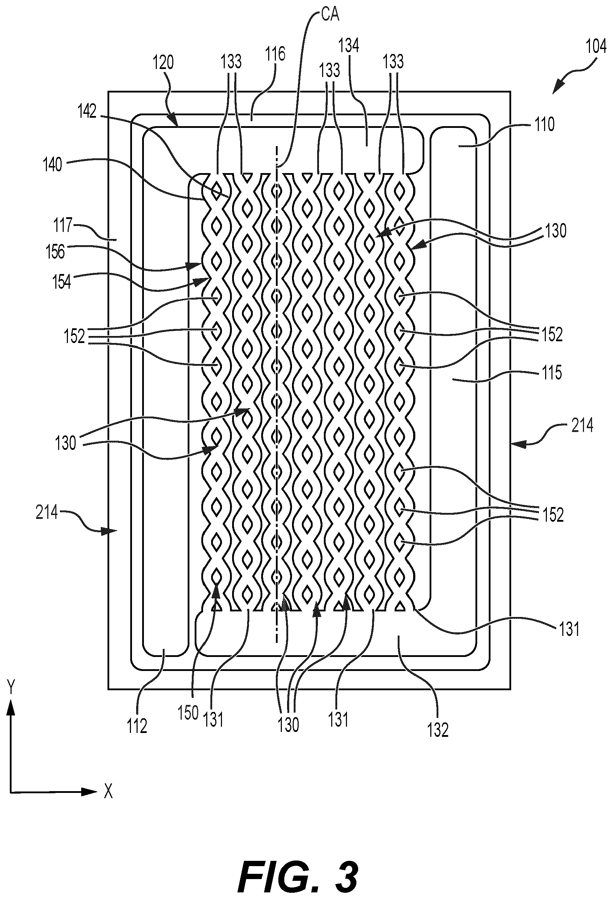

As best seen in FIGs. 2 and 3, the cover 106 is received in a pocket 120 defined by the base 104 such that a lower surface 114 of the cover 106 is in contact with an upper surface 116 of the base 104. The upper surface 116 and a rim portion 117 of the base 104 define the pocket 120 of the base 104 in which the cover 106 is received. The lower surface 114 of the cover 106 is disposed on the upper side 116 of the base 104 (i.e., on an opposite side from the thermal transfer surface 108) and therefore is offset from the thermal transfer surface 108 in a height direction (i.e., along the Z-axis) of the cooling block 100 that is normal to the thermal transfer surface 108. The rim portion 117 may be considered as a shelf on which the cover 106 and/or at least one connector will rest. In other embodiments, the base 104 may not define a pocket 120 to receive the cover 106 (e.g., the cover 106 may be welded to the base 104 along a periphery thereof). In such embodiments, the upper surface 116 of the base 104 is not surrounded by the rim portion 117.

In this embodiment, the cover 106 is a plate member that is generally planar and shaped to be received within the pocket 120. Notably, the lower surface 114 of the cover 106 is a flat surface that closes off the fluid conduit 115 from its upper side. It is contemplated that, in other embodiments, the cover 106 could define the path of the fluid conduit 115 in part or in its entirety (e.g., the passages 130 could instead be defined by the cover 106, or the passages 130 could also be partially defined by both the base 104 and the cover 106).

With reference to FIG. 3, a path of the fluid conduit 115 is defined by the base 104 which is manufactured to have passages 130 for the cooling fluid to flow therethrough. The passages 130 may be formed by milling, for example. It will be appreciated that each passage 130 has an open-channel configuration before the cover 106 is connected to base 104. The cover 106 closes the open-channel configuration of the passages 130 to form the fluid conduit 115. The fluid conduit 115 has an inlet manifold portion 132 that extends from the inlet 110 and an outlet manifold portion 134 that extends from the outlet 112. The passages 130 extend between the inlet and outlet manifold portions 132, 134 thereby fluidly connecting the inlet manifold portion 132 to the outlet manifold portion 134. The passages 130 are parallel to each other and extend in a longitudinal direction (i.e., along the Y-axis) of the cooling block 100. In addition, the passages 130 are in a parallel flow configuration whereby cooling fluid flows through the multiple passages 130 in parallel rather than in series. In other words, as cooling fluid flows from the inlet 110 to the outlet 112 of the fluid conduit 115, the cooling fluid flow is split between the passages 130. It is contemplated that, in other embodiments, the inlet and outlet manifolds 132, 134 may be omitted. For instance, multiple passages 130 may be fluidly connected to each other in series rather than in parallel (not shown).

Still referring to FIG. 3, the passage 130 extends between an inlet point 131 and an outlet point 133 along the longitudinal direction of the cooling block 100. The outlet point 133 is downstream from the inlet point 131. In this embodiment, the inlet and outlet points 131, 133 are located at the inlet and outlet manifold portions 132, 134 respectively. Each passage 130 is defined between opposite internal sidewalls 140, 142 extending between the inlet and outlet points 131, 133 and facing each other such that, as cooling fluid flows within the passage 130, the cooling fluid is bound between the internal sidewalls 140, 142.

In this embodiment, the passage 130 is also defined in part by a pin row 150 including a multitude of pins 152 of the base 104. In use, the pins 152 deflect the cooling fluid flowing within the fluid conduit 115 toward either side of a central linear axis CA (FIG.3). As can be seen, the pin row 150 is disposed between the opposite internal sidewalls 140, 142. The pins 152 of the pin row 150 are spaced apart along the longitudinal direction and aligned with each other in the lateral direction such that the central linear axis CA traverses each pin 152. As can be seen, this arrangement of the pin row 150 imparts the passage 130 with a catenulate (i.e., chain-like) shape. More specifically, in this embodiment, the passage 130 has a plurality of constricted portions 154 and a plurality of expanded portions 156 disposed alternatingly along the longitudinal direction and which impart, together with the pins 152, the catenulate shape to the passage 130. The expanded portions 156 of the passage 130 are formed by the rounded sections 144 of the internal sidewalls 140, 142. The constricted and expanded portions 154, 156 are referenced as such due to their relative dimensions. Notably, the expanded portions 156 of the passage 130 have a width that is greater than a width of the constricted portions 154. The widths of the constricted and expanded portions 154, 156 are measured along the lateral direction. In this embodiment, the pins 152 are disposed along the expanded portions 156 (i.e., the pins 152 of the pin row 150 are contained within respective ones of the expanded portions 156). It will be appreciated that the pins 152 are optional and may be omitted in certain embodiments. For example, in certain embodiments, the passage 130 comprises a channel with a serpentine configuration.

As shown in both the embodiments of FIGs. 1 and 5, the cooling block 100 is provided with at least one connector 200, 300 for connecting to the inlet 110 and the outlet 112, respectively. The at least one connector 200, 300 is configured to fluidly connect the inlet 110 and the outlet 112 with a fluid source through piping, for example.

Referring first to the embodiment of FIG. 1, there are provided two connectors 200 connected to the body 102 at the top side 109 of the cooling block 100. It will be appreciated that the top side 109 of the cooling block is flush with an upper face of the cover 106. The cover 106 has two recessed portions 202 sized and shaped so that each connector 200 can be positioned in the respective recessed portion 202. When the base 104, the cover 106 and the connectors 200 are connected together, the connectors 200 are disposed at the respective recessed portions 202 of the cover 106 and can be fluidly connected with the inlet 110 and the outlet 112.

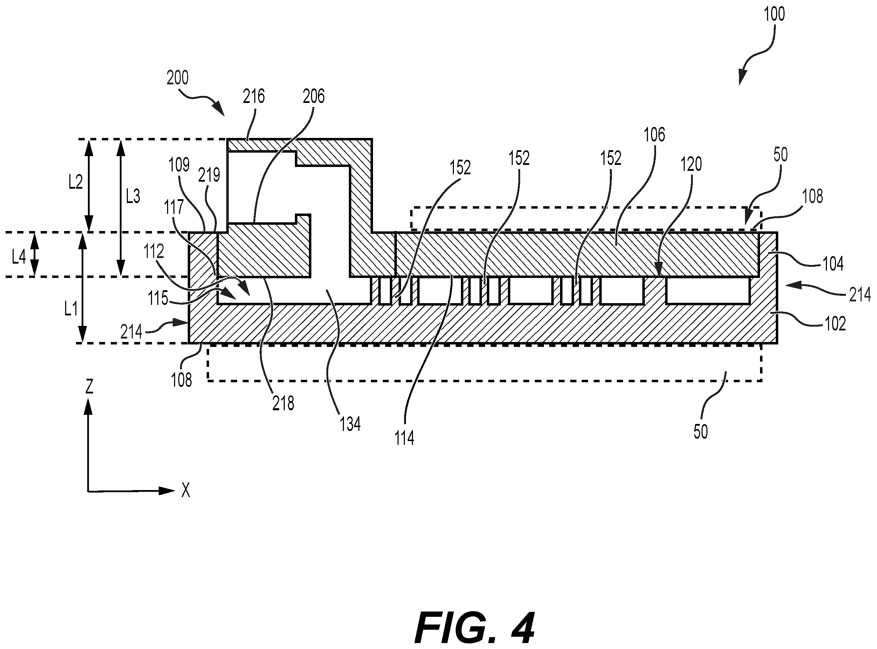

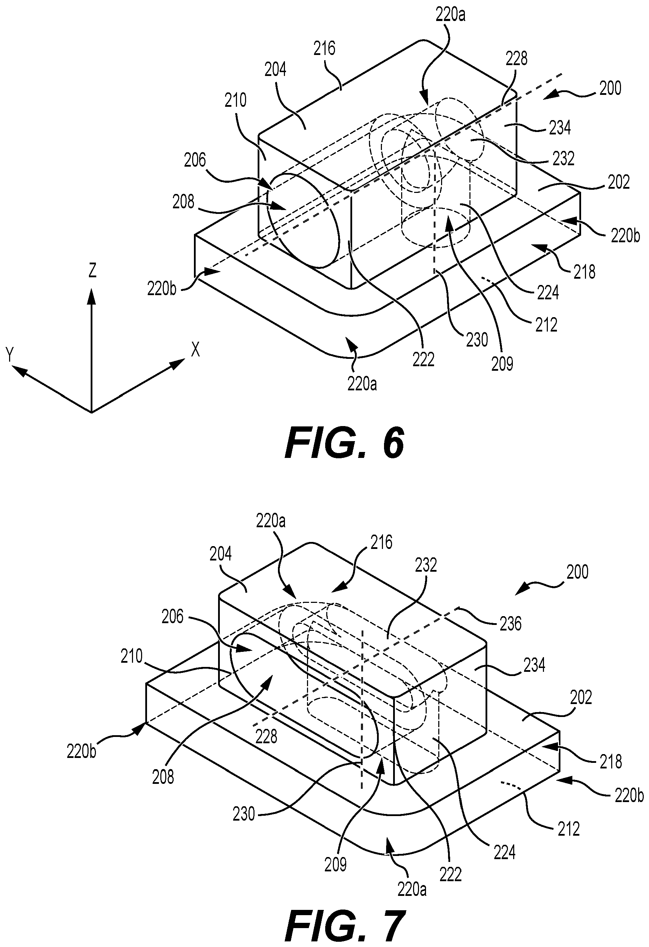

As best seen in FIG. 6, each connector 200 has a connector body 204 defining a connector passage 206 therein. When one of the connectors 200 is connected to the body 102, the connector passage 206 is in fluid communication with the outlet 112 (FIG. 4). Similarly, when the other of the connectors 200 is connected to the body 102, the connector passage 206 is in fluid communication with the inlet 114. The connectors 200 of FIG. 6, can thus be termed "single passage connectors".

The piping (not shown) can be fluidly connected to the connector passage 206 of each connector 200 to route cooling fluid to the cooling block 100 from the fluid source and discharge cooling fluid from the cooling block 100, respectively. In this respect, each connector passage 206 has one end 208 that opens to a side face 210 of the connector 200, and another end 209 (also referred to as 'inlet/outlet end') that opens to a lower face 212 of the connector 200. The end 208 (also referred to as 'piping end') of the connector passage 206 at the side face 210 is configured to fluidly connect with the piping.

A shape of the connector 200 and a shape of the recessed portion 202 are configured such that when the connector 200 is assembled with the base 104 and the cover 106, the side face 210 is facing away from a side 214 of the cooling block 100. This may reduce an interference of the piping, when attached to the connector 200, with the thermal transfer surface(s) 108, thereby making available more or all of the thermal transfer surface(s) 108 for contact with the heat-generating electronic component(s) 50.

The connector body 204 has an upper portion 216 and a lower portion 218. The upper portion 216 has upper face 125, 127. Both the upper portion 216 and the lower portion 218 of the connector body 204 are cuboid. The lower portion 218 has a width and a depth (i.e. along the x- and y- axis) which is larger than a width and a depth of the upper portion 216. In other embodiments, the upper and/or lower portion 216, 218 may have any configuration other than cuboid. In yet other embodiments, the upper and the lower portions 216, 218 may have any other relative configuration. For example, they may have a same configuration.

The lower portion 218 is sized and shaped to rest on the shelf of the rim portion 117 of the base 104 of the cooling block 100 and aligned with the recessed portion 202 of the cover 106 when the cover 106 is positioned on the base 104. A height L4 of the lower portion 218, the rim portion 117 and the cover 106 are substantially the same such that an upper surface 219 of the lower portion 218 of the connector 200 is flush with the top side 109 of the cooling block 100 (FIG. 4). The lower portion 218 being wider and deeper than the upper portion 216 may also facilitate handling of the connector 200.

Furthermore, according to embodiments of the present technology, a height L3 of the connector 200 is more than a height L1 of the cooling block body. The upper portion 216 extends outwardly away from the cover 106 by a height L2. In fact, the height of the upper portion 216 must be able to accommodate a connection with piping of a certain size, for example 6 mm diameter. L1 is less than or equal to L2. L1 is less than L3.

In certain embodiments, the height of the connector L3 is less than about 12 mm, about 11 mm or about 10 mm.

The lower portion 218 of the connector body 204 has four corners 220, two of which are rounded 220a and two of which are angular 200b. The two-rounded corners 220a are diametrically opposed to one another, and the two angular corners 220b are diametrically opposed to one another. As the recessed portion 202 of the cover 106 is rounded, the connector 200 can only be positioned in the recessed portion 202 with the rounded corners 220a nesting in the rounded recessed portion 202. As will be appreciated, this permits two orientations of the connector 200 in each recessed portion 202: one orientation in which the side face 210 of the connector 200, which defines therein the end 208 of the connector passage 206, is facing away from the cooling block 200, and another orientation in which the side face 210 of the connector 200 is facing towards the cooling block 100. In certain embodiments, the orientation is selected such that the side face 210 of the connector 200, which defines therein the end 208 of the connector passage 206, is facing away from the cooling block 100. This can reduce or avoid an interference of the piping, when it is attached to the end 208 of the connector passage 206 at the side face 210, with one or both of the thermal transfer surfaces 108.

With continued reference to FIG. 6, the connector passage 206 comprises a first branch 222 which opens to the side face 210 of the connector body 204 with the end 208 of the connector passage 206 defined therein, and a second branch 224 fluidly communicating with the first branch 222 with the other end 209 which opens to the lower face 212 of the connector body. In other words, the side face 210 of the connector body 204 has an opening formed therein which is the end 208 of the connector passage 206, and the lower face 212 has an opening formed therein which is the other end of the connector passage 206. In certain embodiments, when the connector passage 206 is in fluid communication with the inlet 110 and/or the outlet 112, the opening in the side face 210 faces away from the cooling block 200.

In the embodiments which are illustrated, the first branch 222 has a first branch longitudinal axis 228 which is substantially aligned with the x-axis (e.g. horizontal in use) and the second branch 224 has a second branch longitudinal axis 230 which is substantially aligned with the z-axis (e.g. vertical in use). The first and second branch longitudinal axes 228, 230 are angled at about 90 degrees to one another. In other words, the connector passage 206 is L-shaped. In other embodiments, an angle of the longitudinal axes 228, 230 of the first and second branches 222, 224 may range between about 80 degrees and about 180 degrees, or about 80 degrees to about 150 degrees. In other words, the connector passage 206 may be elbow-shaped. The angle of the longitudinal axes 228, 230 may be selected such that they avoid an unacceptable pressure drop in the fluid flowing therein.

In other embodiments (not shown), the connector passage 206, comprising the first branch 222 and the second branch 224, extends from a top face of the connector body 204 to the lower face 212 of the connector body. In other words, the end 208 of the connector passage 206 opens to the top face and the other end 209 opens to the lower face 212 of the connector body 204. An angle between the longitudinal axes 228, 230 of the first and second branches 222, 224 may range between about 80 degrees and about 180 degrees, or about 80 degrees to about 150 degrees.

In the embodiments of FIG. 6, the connector passage 206 has a cross-sectional shape which is circular. A diameter of the first branch 222 is larger than a diameter of the second branch 224. In other embodiments, the diameters may be same. In yet other embodiments, the diameter of the first branch 222 is smaller than the diameter of the second branch 224.

Referring now to FIG. 7, in certain other embodiments, the cross-sectional shape of the connector passage 206 is a flattened elliptical, with a width (along the y-axis) of the connector passage 206 being wider than a height (along the x-axis). In other embodiments, the cross-sectional shape of the connector passage 206 may be elliptical (not-flattened). An advantage of the flattened elliptical configuration is that the height L2 of the upper portion 216 of the connector body 204 which extends beyond the cover 106 (shown in FIGs. 1 and 4) can be reduced without compromising the flow of the cooling fluid through the connector passage 206. In some embodiments, the height L2 of the connector body extending beyond the cover 106 is less than about 6 mm. In some embodiments, the height L2 is about 6 mm or about 5 mm. In such embodiments, a height of the connector body L3 is about 10 mm or less than about 10 mm. It will be appreciated that the cross-sectional shape of the connector passage 206 may differ from that illustrated herein. For example, instead of the cross-sectional shape being circular or elliptical, the cross-sectional shape may have any other form such oval, rectangular, etc.

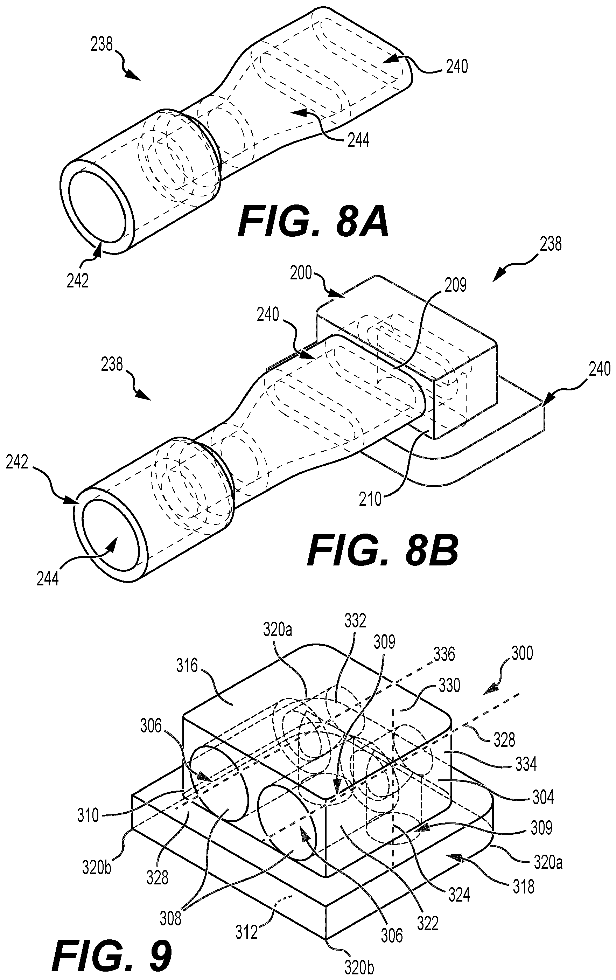

As shown in FIG. 8A and 8B, in such embodiments in which the cross-sectional shape of the connector passage 206 is elliptical or flattened elliptical, there may be provided an adaptor member 238 having an end portion 240 connectable to the end 208 of the connector passage 206 at the side face 210 of the connector body 204, and another end portion 242 which is connectable to the piping. A cross-sectional shape of the adaptor member 238 at the end portion 240 corresponds to the cross-sectional shape of the connector passage 206 at the opening at the side face 210, i.e. elliptical or flattened elliptical. A cross-sectional shape of the adaptor member 238 at the other end portion 242 corresponds to a cross-sectional shape of the piping (e.g. circular). The adaptor member 238 has an adaptor passage 244 defined therein which has a cross-sectional shape which transitions, from the end portion 240 towards the other end portion (e.g. distal end) 242, from the flattened elliptical/elliptical cross-sectional profile to a circular cross-sectional profile. Other combinations of cross-sectional shapes are within the scope of the present technology. As seen in FIG. 8A and 8B, the end portion 242 of the adaptor member 238 is embodied as an elongate arm, for receiving a circular piping. Other configurations are possible.

In certain embodiments, the transition between the end portion 240 and the other end portion (e.g. distal end) 242 is such that a wall thickness of the adaptor member 238 is substantially constant along at least a portion of a length of the adaptor member 238. The cross-sectional shape of the adaptor member 238 may transition linearly between the end portion 240 and the other end portion (e.g. distal end) 242. A ratio of an inner diameter to an inner width of the adaptor passage 244 comprises 4:1 in certain embodiments.

In the embodiments of FIGs. 8A and 8B, the adaptor member 238 is separate and connectable to the connector 200. Corresponding ends of the adaptor member 238 and the connector 200 may be threaded to facilitate a threaded connection.

In other embodiments, the adaptor member 238 and the connector 200 may be one-piece manufactured using additive manufacturing, or any other suitable method.

Referring now to FIGs. 5 and 9, unlike the embodiment of FIG. 1 in which the cooling block 100 had two connectors 200, each with a single connector passage 206, and two recessed portions 202 in the cover 106, in the embodiment of FIG. 5, the cooling block 100 has a cover 106 with a single recessed portion 302, and one connector 300 which is fluidly connectable to both the inlet 110 and the outlet 112 of the cooling block 100. In these embodiments, the inlet 110 and the outlet 112 are disposed at a same or adjacent location in the base 104. As shown in FIG. 9, the connector 300 has a connector body 304 having defined therein two connector passages 306 which are configured to respectively fluidly connect with the inlet 110 and the outlet 112. The connector passages 306 are disposed side-by-side. The connectors 300 of FIGs. 5 and 9, can thus be termed "double passage connectors".

As with the embodiment of the connector of FIG. 6, in the connector 300 of FIG. 9, each connector passage 306 extends between a side face 310 of the connector 300 and the lower face 312 of the connector body 304. One end 308 of each connector passage 306 open to the side face 310, and an other end 309 opens to the lower face 312 of the connector body 304. Each connector passage 306 has a first branch 322 in fluid communication with a second branch 324. The connector body 304 has an upper portion 316 and a lower portion 318, the lower portion 318 being wider and deeper than a width and depth of the upper portion 316 of the connector body 304. In the embodiment of FIG. 9, each connector passage 306 has a circular cross-sectional profile. The lower portion 318 of the connector 300 has two rounded corners 320a which are adjacent one another and two angular corners 320b which are adjacent one another. As for the connector 200, the configuration of the rounded and angular corners 320a, 320b determine an orientation of the connector 300 in the recessed portion 302 of the cover 106. Although illustrated as having a circular cross-sectional shape, the cross-sectional shape of the connector passages 36 may be any other shape, and may have a same or different shape to each other.

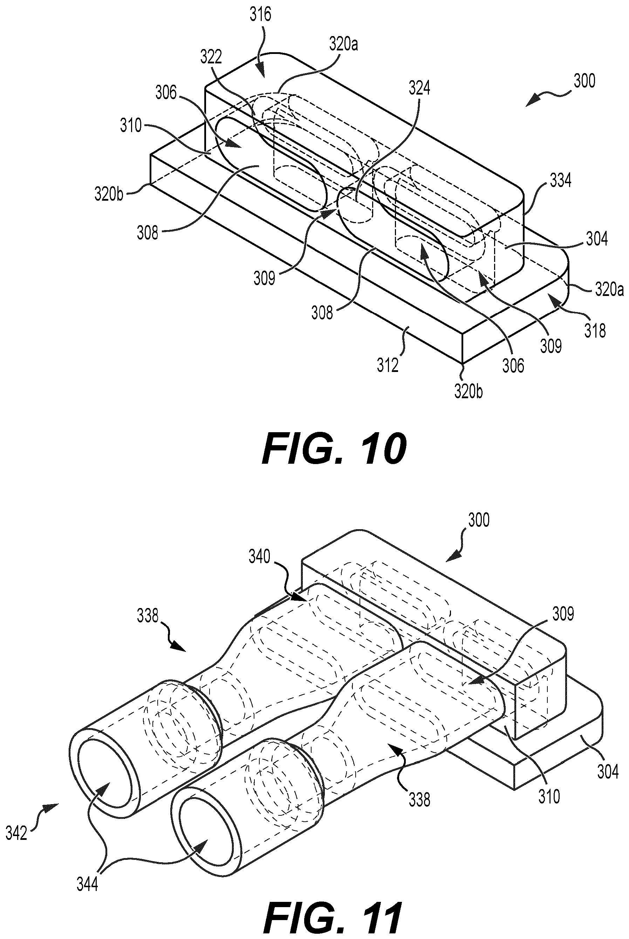

FIG. 10 illustrates a variation of the connector 300 of FIG. 9, in which the connector passage 306 of the connector 300 has a flattened elliptical cross-sectional shape. Each connector passage 306 may have the same configuration as the connector passage 206 of the connector 200 of FIG. 7. A height of the connector 300 which extends beyond the cover 106 when the connector 300 is connected to the base 104 and the cover 106 may be less than about 6 mm.

As shown in FIG. 11, there may also be provided adaptor members 338 configured to connect with the connector of FIG. 10, each having an adaptor passage 344, each of which extend between one end portion 340 of the adaptor member 338 which will fluidly communicate with the end 309 of the connector passage 306 opening on the side face 310 of the connector body 304 in use, and another end portion 342 which will fluidly connect with the piping in use.

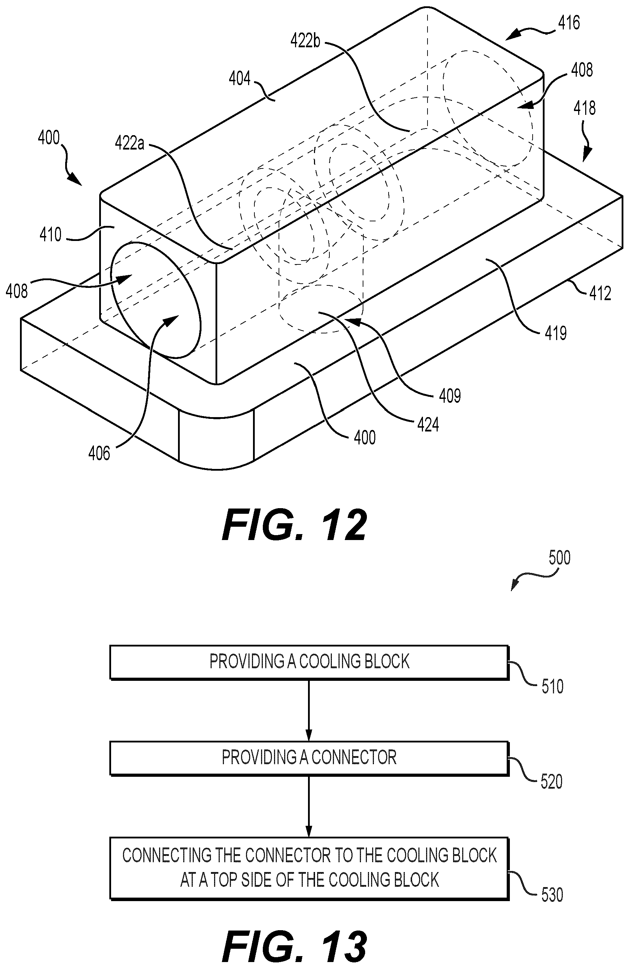

Referring now to FIG. 12, there is provided, in certain examples useful to understand but out of the scope of the present technology, a connector 400 having a connector body 404 and a connector passage 406 defined therein which is T-shaped. That is the connector passage 406 has first branches 422a, 422b in fluid communication with each other and a second branch 424. The first branches 422a, 422b have ends 408 which open on side faces 410 of the connector and are substantially longitudinally aligned with one another. The second branch 424 is fluidly connected to the first branches 422a, 422b and extends to a lower face 412 of the connector body 404. In certain embodiment, the use of two connectors 400 on a cooling block 100 allows to fluidly connect in a parallel configuration the cooling block 100 to other similar cooling blocks, equipped either with two connectors 400 or with two connectors 200.

The connector body 404 has an upper portion 416 and a lower portion 418, the lower portion 418 being wider and deeper than a width and depth of the upper portion 416 of the connector body 404. In the embodiment of FIG. 12 each connector passage 406 has a circular cross-sectional profile. However, the cross-sectional shape of the connector passages 406 may be any other shape, and may have a same or different shape to each other. The lower portion 418 of the connector 400 has rounded and angular corners which can determine an orientation of the connector 400 in the recessed portion 302 of the cover 106.

In other embodiments (not shown), a double version of the connector 400 may be provided in which there are two connector passages 406 side-by-side.

In yet other embodiments, there may be provided a connector (not shown) having two branches which open to the lower face of the connector and a single branch opening to the side face of the connector. Instead of opening to the side face, one or more branches may open to another side face or to a top face of the connector.

It will be appreciated that the connectors 200, 300 and the covers 106 with the recessed portions 202, 302 may be provided separately and connected with existing bases of cooling blocks 100. The connectors 200, 300 may be interchangeable with one another. According to certain embodiments of the present technology, use of the connectors 200, 300 in cooling blocks 100 can avoid the use of piping that is directly connected to the top side 109 of the cooling block 100, thereby enabling easier access to the thermal transfer surfaces 108, and enabling positioning of heat-generating electronic components to both sides of the cooling block. In embodiments where only one heat-generating electronic component is cooled per cooling block 100, stacking of the cooling block and heat-generating electronic component pairs may be facilitated. Furthermore, use of separate and connectable connectors for connecting the cooling block with the piping can enable less material to be used within the cooling block, thereby providing cost savings.

The connectors 200, 300, 400 may be made using any suitable method. In certain embodiments, the connectors 200, 300, 400 are made by additive manufacturing. In certain other methods, the connectors 200, 300, 400 may be made by machining. The connectors 200, 300, 400 may be made of any suitable material such as copper. The adaptor members 238, 338 may also be made by additive manufacturing. The adaptor members 238, 338 and the connectors 200, 300, 400 may be made separately and connected together such as by threaded connection and/or welded together, or may be made as a single piece, such as by additive manufacturing.

The cooling blocks 100 described herein may be assembled using a method 500. Referring to FIG. 13, according to certain embodiments, the method comprises, in Step 510: providing a cooling block, such as the cooling block 100 comprising the base 104 and the cover which when connected define the fluid conduit 15. In Step 520, the method 500 comprises providing a connector having a connector body defining therein at least one connector passage. The connector may comprise the connector 200, 300 having the connector body 204, 304 defining therein the connector passage 206, 306. In Step 530, the method 500 comprises connecting the connector to the cooling block body at a top side of the cooling block body such that the at least one connector is in fluid communication with one or both of the conduit inlet and the conduit outlet of the cooling block.

In certain embodiments, the method 500 further comprises providing an adaptor, such as the adaptor 238 or 338, and connecting it to the connector 200, 300, 400. Alternatively, the step of providing the connector may comprise the connector also including an adaptor attached to one end of the connector 200, 300, 400.

In certain embodiments, connecting the connector to the cooling block body may comprise positioning the connector in a pocket of a base of the cooling block, with a portion of the connector extending beyond the cooling block body. A height of the connector may be more than a height of the cooling block body.

In certain embodiments, the at least one connector is oriented such that the at least one connector passage extends between a side face of the connector body to a lower face of the connector body, the lower face of the connector body being in contact with the top side of the cooling block.

In certain embodiments, connecting the connector to the top side of the cooling block body comprises positioning the cover on the base and positioning the connector in the recessed portion. A lower portion of the connector may be shaped such that the connector can be positioned in the recessed portion in one or two predetermined orientations.

In certain embodiments, the connector is connected to the base by welding, and the cover is connected to the base by welding, and the connector is connected to the cover by welding.

## Claims

1. A cooling block (100) for cooling a heat-generating electronic component (50), the cooling block (100) comprising:
a cooling block body (102) defining a fluid conduit (115) therein for circulating a cooling fluid therethrough, the fluid conduit having a conduit inlet (110) and a conduit outlet (112) for receiving and discharging the cooling fluid respectively,
a connector (300) connected to the cooling block body (102) at a top side of the cooling block body (102) , the connector (300) having a connector body (304) defining two connector passages (306), the two connector passages (306) being disposed side-by-side, in fluid communication with the conduit inlet (110) and the conduit outlet (112) respectively, and fluidly connectable to piping of a fluid source, and
wherein the two connector passages (306) extend between a side face (310) of the connector body (304) and a lower face of the connector body (312).

2. The cooling block of claim 1, wherein a height (L1) of the cooling block body is less than a height (L3) of the connector body (304).

3. The cooling block of claim 2, wherein a portion (316) of the connector (300) protrudes outwardly from the cooling block body when the connector (300) is connected to the cooling block body (102).

4. The cooling block of any of claims 1-3, wherein the connector (300) is positioned such that the side face (310) faces away from the cooling block (100).

5. The cooling block (100) of any of claims 1-4, wherein the two connector passages (306) are L-shaped or T-shaped.

6. The cooling block (100) of any of claims 1-5, wherein a cross-sectional shape of each connector passage (306) of the two connector passages (306) is: circular, or a flattened elliptical in which a width of each connector passage (306) of the two connector passages (306) is larger than a height of each connector passage (306) of the two connector passages (306), and optionally further comprising an adaptor member (338) connectable to an end (309) of the two connector passages (306) and having a cross-sectional shape which transitions, towards a distal end (340), from a flattened elliptical cross-sectional profile to a circular cross-sectional profile .

7. The cooling block (100) of any of claims 1-6, wherein the cooling block body (102) comprises a base (104) connected to a cover (106), wherein the cover (106) has at least one recessed portion (202), the connector (300) being connected to the base (104) and to the cover (106) at the at least one recessed portion (302).

8. The cooling block (100) of claim 7, wherein a surface area of a top face of the upper portion (316) of the connector (300) is smaller than a surface area of a top face of the cover (106).

9. A connector (300) for a cooling block (100), the connector (300) having a connector body (304) defining two connector passages (306), the two connector passages (306) being disposed side-by-side, the connector (300) being connectable to a top side of the cooling block body (102) such that the two connector passages (306) are in fluid communication with a conduit inlet (110) and a conduit outlet (112) of the cooling block (100), and fluidly connectable to piping of a fluid source, and
wherein the two connector passages (306) extend between a side face (310) of the connector body (304) and a lower face of the connector body (312).

10. The connector (300) of claim 9, wherein the two connector passages (306) extend between an upper portion (316) of the connector body (304) and a lower portion (318) of the connector body (304), and optionally has a T-shape or an L-shape configuration.

11. The connector (300) of claim 9 or claim 10, wherein a cross-sectional shape of each connector passage (306) of the two connector passages (306) is circular, or a flattened elliptical (306) in which a width of each connector passage (306) of the two connector passages (306) is larger than a height of each connector passage (306) of the two connector passages (306), and optionally further comprising an adaptor member (338) connectable to an end (309) of the two connector passages (306) and having a cross-sectional shape which transitions, towards a distal end (340), from a flattened elliptical cross-sectional profile to a circular cross-sectional profile.

12. A method of assembling a cooling block (100), the method comprising:
providing a cooling block (100) comprising a cooling block body (102) defining a fluid conduit (115) therein for circulating a cooling fluid therethrough, the fluid conduit (115) having a conduit inlet (110) and a conduit outlet (112) for receiving and discharging the cooling fluid respectively;
providing a connector (300) having a connector body (304) defining therein two connector passages being disposed side-by-side (306);
connecting the connector (300) to the cooling block body (102) at a top side of the cooling block body (102) such that the connector (300) is in fluid communication with both the conduit inlet (110) and the conduit outlet (112) of the cooling block (100), and
wherein the connector (300) is oriented such that each of the two connector passages (306) extend between a side face (310) of the connector body (304) to a lower face (312) of the connector body (302).

13. The method of claim 12, wherein connecting the connector (300) to the cooling block body (102) comprises positioning the connector (300) in a pocket (120) of a base (104) of the cooling block (100), with a portion of the connector (300) extending beyond the cooling block body (102), and a height (L3) of the connector (300) is more than a height (L1) of the cooling block body (102).

14. The method of claim 12 or 13, wherein the lower face (312) of the connector body (304) is in contact with the top side (109) of the cooling block (100).

15. The method of any of the claims 12 to 14, wherein the connecting the connector (300) to the cooling block body (102) comprises welding the connector (300) to the cooling block body (102)

## Patentansprüche

1. Kühlblock (100) zum Kühlen eines wärmeerzeugenden elektronischen Bauteils (50), wobei der Kühlblock (100) Folgendes umfasst:
einen Kühlblockkörper (102), der eine Fluidleitung (115) darin zum Zirkulieren eines Kühlfluids dadurch definiert, wobei die Fluidleitung einen Leitungseinlass (110) und einen Leitungsauslass (112) zum Aufnehmen beziehungsweise Abgeben des Kühlfluids aufweist,
einen Verbinder (300), der an einer Oberseite des Kühlblockkörpers (102) mit dem Kühlblockkörper (102) verbunden ist, wobei der Verbinder (300) einen Verbinderkörper (304) aufweist, der zwei Verbinderdurchgänge (306) definiert, wobei die zwei Verbinderdurchgänge (306) nebeneinander angeordnet sind, in Fluidkommunikation mit dem Leitungseinlass (110) beziehungsweise dem Leitungsauslass (112) sind und fluidisch mit Rohrleitungen einer Fluidquelle verbindbar sind und
wobei sich die zwei Verbinderdurchgänge (306) zwischen einer seitlichen Fläche (310) des Verbinderkörpers (304) und einer unteren Fläche des Verbinderkörpers (312) erstrecken.

2. Kühlblock nach Anspruch 1, wobei eine Höhe (L1) des Kühlblockkörpers geringer als eine Höhe (L3) des Verbinderkörpers (304) ist.

3. Kühlblock nach Anspruch 2, wobei ein Abschnitt (316) des Verbinders (300) nach außen aus dem Kühlblockkörper herausragt, wenn der Verbinder (300) mit dem Kühlblockkörper (102) verbunden ist.

4. Kühlblock nach einem der Ansprüche 1 bis 3, wobei der Verbinder (300) derart positioniert ist, dass die seitliche Fläche (310) von dem Kühlblock (100) weg zeigt.

5. Kühlblock (100) nach einem der Ansprüche 1 bis 4, wobei die zwei Verbinderdurchgänge (306) L-förmig oder T-förmig sind.

6. Kühlblock (100) nach einem der Ansprüche 1 bis 5, wobei eine Querschnittsform jedes Verbinderdurchgangs (306) der zwei Verbinderdurchgänge (306) Folgendes ist: kreisförmig oder eine abgeflachte Ellipse, bei der eine Breite jedes Verbinderdurchgangs (306) der zwei Verbinderdurchgänge (306) größer als eine Höhe jedes Verbinderdurchgangs (306) der zwei Verbinderdurchgänge (306) ist, und
optional ferner umfassend ein Anpassungselement (338), das mit einem Ende (309) der zwei Verbinderdurchgänge (306) verbindbar ist und eine Querschnittsform aufweist, die zu einem distalen Ende (340) hin von einem abgeflachten elliptischen Querschnittsprofil in ein kreisförmiges Querschnittsprofil übergeht.

7. Kühlblock (100) nach einem der Ansprüche 1 bis 6, wobei der Kühlblockkörper (102) eine Basis (104) umfasst, die mit einer Abdeckung (106) verbunden ist, wobei die Abdeckung (106) mindestens einen vertieften Abschnitt (202) aufweist, wobei der Verbinder (300) an dem mindestens einen vertieften Abschnitt (302) mit der Basis (104) und mit der Abdeckung (106) verbunden ist.

8. Kühlblock (100) nach Anspruch 7, wobei ein Oberflächenbereich einer oberen Fläche des obenliegenden Abschnitts (316) des Verbinders (300) kleiner als ein Oberflächenbereich einer oberen Fläche der Abdeckung (106) ist.

9. Verbinder (300) für einen Kühlblock (100), wobei der Verbinder (300) einen Verbinderkörper (304) aufweist, der zwei Verbinderdurchgänge (306) definiert, wobei die zwei Verbinderdurchgänge (306) nebeneinander angeordnet sind, wobei der Verbinder (300) derart mit einer Oberseite des Kühlblockkörpers (102) verbindbar ist, dass die zwei Verbinderdurchgänge (306) in Fluidkommunikation mit einem Leitungseinlass (110) und einem Leitungsauslass (112) des Kühlblocks (100) sind und mit Rohrleitungen einer Fluidquelle fluidisch verbindbar sind und
wobei sich die zwei Verbinderdurchgänge (306) zwischen einer seitlichen Fläche (310) des Verbinderkörpers (304) und einer unteren Fläche des Verbinderkörpers (312) erstrecken.

10. Verbinder (300) nach Anspruch 9, wobei sich die zwei Verbinderdurchgänge (306) zwischen einem obenliegenden Abschnitt (316) des Verbinderkörpers (304) und einem untenliegenden Abschnitt (318) des Verbinderkörpers (304) erstrecken und optional eine T-förmige oder eine L-förmige Konfiguration aufweisen.

11. Verbinder (300) nach Anspruch 9 oder Anspruch 10, wobei eine Querschnittsform jedes Verbinderdurchgangs (306) der zwei Verbinderdurchgänge (306) kreisförmig oder eine abgeflachte Ellipse (306) ist, bei der eine Breite jedes Verbinderdurchgangs (306) der zwei Verbinderdurchgänge (306) größer als eine Höhe jedes Verbinderdurchgangs (306) der zwei Verbinderdurchgänge (306) ist, und optional ferner umfassend ein Anpassungselement (338), das mit einem Ende (309) der zwei Verbinderdurchgänge (306) verbindbar ist und eine Querschnittsform aufweist, die zu einem distalen Ende (340) hin von einem abgeflachten elliptischen Querschnittsprofil in ein kreisförmiges Querschnittsprofil übergeht.

12. Verfahren zum Zusammenbauen eines Kühlblocks (100), wobei das Verfahren Folgendes umfasst:
Bereitstellen eines Kühlblocks (100), umfassend einen Kühlblockkörper (102), der eine Fluidleitung (115) darin zum Zirkulieren eines Kühlfluids dadurch definiert, wobei die Fluidleitung (115) einen Leitungseinlass (110) und einen Leitungsauslass (112) zum Aufnehmen beziehungsweise Abgeben des Kühlfluids aufweist;
Bereitstellen eines Verbinders (300), der einen Verbinderkörper (304) aufweist, der darin zwei Verbinderdurchgänge definiert, die nebeneinander angeordnet sind (306);
derartiges Verbinden des Verbinders (300) mit dem Kühlblockkörper (102) an einer Oberseite des Kühlblockkörpers (102), dass der Verbinder (300) in Fluidkommunikation mit sowohl dem Leitungseinlass (110) als auch dem Leitungsauslass (112) des Kühlblocks (100) ist, und
wobei der Verbinder (300) derart ausgerichtet ist, dass sich jeder der zwei Verbinderdurchgänge (306) zwischen einer seitlichen Fläche (310) des Verbinderkörpers (304) und einer unteren Fläche (312) des Verbinderkörpers (302) erstreckt.

13. Verfahren nach Anspruch 12, wobei das Verbinden des Verbinders (300) mit dem Kühlblockkörper (102) ein Positionieren des Verbinders (300) in einer Aussparung (120) einer Basis (104) des Kühlblocks (100) umfasst, wobei sich ein Abschnitt des Verbinders (300) über den Kühlblockkörper (102) hinaus erstreckt und eine Höhe (L3) des Verbinders (300) größer als eine Höhe (L1) des Kühlblockkörpers (102) ist.

14. Verfahren nach Anspruch 12 oder 13, wobei die untere Fläche (312) des Verbinderkörpers (304) in Kontakt mit der Oberseite (109) des Kühlblocks (100) ist.

15. Verfahren nach einem der Ansprüche 12 bis 14, wobei das Verbinden des Verbinders (300) mit dem Kühlblockkörper (102) ein Verschweißen des Verbinders (300) mit dem Kühlblockkörper (102) umfasst.

## Revendications

1. Bloc de refroidissement (100) pour refroidir un composant électronique générant de la chaleur (50), le bloc de refroidissement (100) comprenant :
un corps de bloc de refroidissement (102) définissant un conduit de fluide (115) dans celui-ci pour faire circuler un fluide de refroidissement à travers celui-ci, le conduit de fluide ayant une entrée de conduit (110) et une sortie de conduit (112) pour recevoir et évacuer le fluide de refroidissement respectivement,
un raccord (300) raccordé au corps de bloc de refroidissement (102) au niveau d'un côté supérieur du corps de bloc de refroidissement (102), le raccord (300) ayant un corps de raccord (304) définissant deux passages de raccord (306), les deux passages de raccord (306) étant disposés côte à côte, en communication fluidique avec l'entrée de conduit (110) et la sortie de conduit (112) respectivement, et pouvant être raccordé de manière fluidique à une tuyauterie d'une source de fluide, et
dans lequel les deux passages de raccord (306) se prolongent entre une face latérale (310) du corps de raccord (304) et une face inférieure du corps de raccord (312).

2. Bloc de refroidissement selon la revendication 1, dans lequel une hauteur (L1) du corps de bloc de refroidissement est inférieure à une hauteur (L3) du corps de raccord (304).

3. Bloc de refroidissement selon la revendication 2, dans lequel une partie (316) du raccord (300) fait saillie vers l'extérieur depuis le corps de bloc de refroidissement lorsque le raccord (300) est raccordé au corps de bloc de refroidissement (102).

4. Bloc de refroidissement selon l'une quelconque des revendications 1 à 3, dans lequel le raccord (300) est positionné de sorte que la face latérale (310) soit orientée à l'opposé du bloc de refroidissement (100).

5. Bloc de refroidissement (100) selon l'une quelconque des revendications 1 à 4, dans lequel les deux passages de raccord (306) sont en forme de L ou en forme de T.

6. Bloc de refroidissement (100) selon l'une quelconque des revendications 1 à 5, dans lequel une forme en coupe transversale de chaque passage de raccord (306) des deux passages de raccord (306) est : circulaire ou elliptique aplatie dans laquelle une largeur de chaque passage de raccord (306) des deux passages de raccord (306) est supérieure à une hauteur de chaque passage de raccord (306) des deux passages de raccord (306), et
éventuellement, comprenant également un élément adaptateur (338) pouvant être raccordé à une extrémité (309) des deux passages de raccord (306) et ayant une forme en coupe transversale qui, vers une extrémité distale (340), passe d'un profil en coupe transversale elliptique aplati à un profil en coupe transversale circulaire.

7. Bloc de refroidissement (100) selon l'une quelconque des revendications 1 à 6, dans lequel le corps de bloc de refroidissement (102) comprend une base (104) raccordée à un couvercle (106), dans lequel le couvercle (106) a au moins une partie en retrait (202), le raccord (300) étant raccordé à la base (104) et au couvercle (106) au niveau de l'au moins une partie en retrait (302).

8. Bloc de refroidissement (100) selon la revendication 7, dans lequel une zone de surface d'une face supérieure de la partie supérieure (316) du raccord (300) est plus petite qu'une zone de surface d'une face supérieure du couvercle (106).

9. Raccord (300) pour un bloc de refroidissement (100), le raccord (300) ayant un corps de raccord (304) définissant deux passages de raccord (306), les deux passages de raccord (306) étant disposés côte à côte, le raccord (300) pouvant être raccordé à un côté supérieur du corps de bloc de refroidissement (102) de sorte que les deux passages de raccord (306) soient en communication fluidique avec une entrée de conduit (110) et une sortie de conduit (112) du bloc de refroidissement (100), et pouvant être raccordé de manière fluidique à une tuyauterie d'une source de fluide, et
dans lequel les deux passages de raccord (306) se prolongent entre une face latérale (310) du corps de raccord (304) et une face inférieure du corps de raccord (312).

10. Raccord (300) selon la revendication 9, dans lequel les deux passages de raccord (306) se prolongent entre une partie supérieure (316) du corps de raccord (304) et une partie inférieure (318) du corps de raccord (304), et ont éventuellement une configuration en forme de T ou en forme de L.

11. Raccord (300) selon la revendication 9 ou la revendication 10, dans lequel une forme en coupe transversale de chaque passage de raccord (306) des deux passages de raccord (306) est circulaire ou elliptique aplatie (306) dans laquelle une largeur de chaque passage de raccord (306) des deux passages de raccord (306) est supérieure à une hauteur de chaque passage de raccord (306) des deux passages de raccord (306), et éventuellement comprenant également un élément adaptateur (338) pouvant être raccordé à une extrémité (309) des deux passages de raccord (306) et ayant une forme en coupe transversale qui, vers une extrémité distale (340), passe d'un profil en coupe transversale elliptique aplati à un profil en coupe transversale circulaire.

12. Procédé d'assemblage d'un bloc de refroidissement (100), le procédé comprenant :
la fourniture d'un bloc de refroidissement (100) comprenant un corps de bloc de refroidissement (102) définissant un conduit de fluide (115) dans celui-ci pour faire circuler un fluide de refroidissement à travers celui-ci, le conduit de fluide (115) ayant une entrée de conduit (110) et une sortie de conduit (112) pour recevoir et évacuer le fluide de refroidissement respectivement ;
la fourniture d'un raccord (300) ayant un corps de raccord (304) définissant dans celui-ci deux passages de raccord (306) disposés côte à côte ;
le raccordement du raccord (300) au corps de bloc de refroidissement (102) au niveau d'un côté supérieur du corps de bloc de refroidissement (102) de sorte que le raccord (300) soit en communication fluidique avec à la fois l'entrée de conduit (110) et la sortie de conduit (112) du bloc de refroidissement (100), et
dans lequel le raccord (300) est orienté de sorte que chacun des deux passages de raccord (306) se prolonge entre une face latérale (310) du corps de raccord (304) et une face inférieure (312) du corps de raccord (302).

13. Procédé selon la revendication 12, dans lequel le raccordement du raccord (300) au corps de bloc de refroidissement (102) comprend le positionnement du raccord (300) dans une poche (120) d'une base (104) du bloc de refroidissement (100), une partie du raccord (300) se prolongeant au-delà du corps de bloc de refroidissement (102), et une hauteur (L3) du raccord (300) étant supérieure à une hauteur (L1) du corps de bloc de refroidissement (102).

14. Procédé selon la revendication 12 ou 13, dans lequel la face inférieure (312) du corps de raccord (304) est en contact avec le côté supérieur (109) du bloc de refroidissement (100).

15. Procédé selon l'une quelconque des revendications 12 à 14, dans lequel le raccordement du raccord (300) au corps de bloc de refroidissement (102) comprend le soudage du raccord (300) au corps de bloc de refroidissement (102).
